(19) Europäisches Patentamt
European Patent Office
Office européen des brevets

(11) **EP 2 415 090 B1**

(12) **EUROPEAN PATENT SPECIFICATION**

(45) Date of publication and mention
of the grant of the patent:
**23.10.2013  Bulletin 2013/43**

(21) Application number: **10711894.5**

(22) Date of filing: **31.03.2010**

(51) Int Cl.:
***H01L 35/32*** *(2006.01)*

(86) International application number:
**PCT/EP2010/054268**

(87) International publication number:
**WO 2010/115792 (14.10.2010 Gazette 2010/41)**

(54) **THERMOELECTRIC MODULE WITH INSULATED SUBSTRATE**

THERMOELEKTRISCHES MODUL MIT ISOLIERTEM SUBSTRAT

MODULE THERMOÉLECTRIQUE À SUBSTRAT ISOLÉ

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **02.04.2009 EP 09157158**

(43) Date of publication of application:
**08.02.2012  Bulletin 2012/06**

(73) Proprietor: **BASF SE**
**67056 Ludwigshafen (DE)**

(72) Inventors:
• **STEFAN, Madalina Andreea**
  **67063 Ludwigshafen (DE)**

• **SCHIERLE-ARNDT, Kerstin**
  **64673 Zwingenberg (DE)**
• **HUBER, Günther**
  **67071 Ludwigshafen (DE)**
• **HAASS, Frank**
  **64390 Erzhausen (DE)**
• **BLACKBURN, John Stuart**
  **Widnes Cheshire WA8 5AH (GB)**
• **JONES, Ivor Wynn**
  **Chester Cheshire CH4 8AR (GB)**
• **STACKPOOL, Francis**
  **Runcorn Cheshire WA7 4JQ (GB)**
• **HEAVENS, Stephen**
  **Ludlow Shropshire SY8 1EE (GB)**

(56) References cited:
**US-A1- 2002 162 338     US-A1- 2007 028 955**

**Description**

The present invention relates to a thermoelectric module comprising a series of p and n type semiconductors connected in series by conductive contacts which is supported on a substrate having a specific electrical insulation, as well as a process for preparing the thermoelectric module.

Thermoelectric generators and Peltier arrangements as such have been known for some time. p- and n-doped semiconductors which are heated on one side and cooled on the other side transport electrical charges through an external circuit, and electrical work can be performed by a load in the circuit. The efficiency of conversion of heat to electrical energy achieved in this process is limited thermodynamically by the Carnot efficiency. Thus, at a temperature of 1000 K on the hot side and 400 K on the "cold" side, an efficiency of (1000 - 400) : 1000 = 60% would be possible. However, only efficiencies of up to 10% have been achieved to date.

On the other hand, when a direct current is applied to such an arrangement, heat is transported from one side to the other side. Such a Peltier arrangement works as a heat pump and is therefore suitable for cooling apparatus parts, vehicles or buildings. Heating via the Peltier principle is also more favourable than conventional heating, because more heat is always transported than corresponds to the energy equivalent supplied.

A good review of effects and materials is given, for example, by Cronin B. Vining, ITS Short Course on Thermoelectricity, Nov. 8, 1993, Yokohama, Japan.

At present, thermoelectric generators are used, for example, in space probes tor generating direct currents, for cathodic corrosion protection of pipelines, for energy supply to light buoys and radio buoys and for operating radios and television sets. Tne advantages of thermoelectric generators lie in their extreme reliability. For instance, they work irrespective of atmospheric conditions such as atmospheric moisture; there is no fault-prone mass transfer, but rather only charge transfer. It is possible to use any fuels from hydrogen through natural gas, gasoline, kerosene, diesel fuel up to biologically obtained fuels such as rapeseed oil methyl ester.

Thermoelectric energy conversion thus fits extremely flexibly into future requirements such as hydrogen economy or energy generation from renewable energies.

A particularly attractive application is the use for converting (waste) heat to electrical energy in motor vehicles, heating systems or power plants. Thermal energy unutilized to date can even now be recovered at least partly by thermoelectric generators, but existing technologies achieve efficiencies of significantly below 10%, and so a large part of the energy is still lost unutilized. In the utilization of waste heat, there is therefore also a drive toward significantly higher efficiencies.

The conversion of solar energy directly to electrical energy would also be very attractive. Concentrators such as parabolic troughs can concentrate solar energy into thermoelectric generators, which generates electrical energy.

However, higher efficiencies are also needed for use as a heat pump.

Thermoelectrically active materials are rated essentially with reference to their efficiency. A characteristic of thermoelectric materials in this regard is what is known as the Z factor (figure of merit):

$$Z = \frac{S^2 \cdot \sigma}{\kappa}$$

with the Seebeck coefficient S, the electrical conductivity $\sigma$ and the thermal conductivity $\kappa$. Preference is given to thermoelectric materials which have a very low thermal conductivity, a very high electrical conductivity and a very large Seebeck coefficient, such that the figure of merit assumes a maximum value.

The product $S^2 \cdot \sigma$ ( is referred to as the power factor and serves for comparison of the thermoelectric materials.

In addition, the dimensionless product $Z \cdot T$ is often also reported for comparative purposes. Thermoelectric materials known hitherto have maximum values of $Z \cdot T$ of about 1 at an optimal temperature. Beyond this optimal temperature, the values of $Z \cdot T$ are often significantly lower than 1.

A more precise analysis shows that the efficiency ( is calculated from

$$\eta = \frac{T_{high} - T_{low}}{T_{high}} \cdot \frac{M - 1}{M + \dfrac{T_{low}}{T_{high}}}$$

where

$$M = \left[1 + \frac{Z}{2}\left(T_{high} + T_{low}\right)\right]^{\frac{1}{2}}$$

(see also Mat. Sci. and Eng. B29 (1995) 228).

The aim is thus to provide a thermoelectric material having a maximum value of Z and a high realizable temperature differential. From the point of view of solid state physics, many problems have to be overcome here:

A high $\sigma$ requires a high electron mobility in the material, i.e. electrons (or holes in p- conducting materials) must not be bound strongly to the atomic cores. Materials having high electrical conductivity $\sigma$ usually also have a high thermal conductivity (Wiedemann- Franz law), which does not allow Z to be favourably influenced. Materials used at present, such as $Bi_2Te_3$, already constitute compromises. For instance, the electrical conductivity is lowered to a lesser extent by alloying than the thermal conductivity. Preference is therefore given to using alloys, for example $(Bi_2Te_3)_{90}$ $(Sb_2Te_3)_5$ $(Sb_2Se_3)_5$ or $Bi_{12}Sb_{23}Te_{65}$.

For thermoelectric materials having high efficiency, still further boundary conditions preferably have to be fulfilled. For instance, they have to be sufficiently thermally stable to be able to work under operating conditions over the course of years without significant loss of efficiency. This requires a phase which is thermally stable at high temperatures per se, a stable phase composition, and negligible diffusion of alloy constituents into the adjoining contact materials.

For the production of a thermoelectric module, n- and p-conductors are always necessary. In order to arrive at a maximum efficiency of the module, i.e. at a maximum cooling performance in the case of a Peltier arrangement or a maximum generator performance in the case of a Seebeck arrangement, p-conductive and n-conductive material must be as well matched to one another as possible. This relates in particular to the parameters of Seebeck coefficient (ideally $S(n) = -S(p)$), electrical conductivity (ideally $\sigma(n) = \sigma(p)$), thermal conductivity (ideally $\lambda(n) = \lambda(p)$) and coefficient of thermal expansion (ideally $\alpha(n) = \alpha(p)$).

In a thermoelectric module the metals/semiconductor materials are joined together by electrodes (for transportation of the generated current) and electrically isolated from other external parts. The electrodes are contacted with an electrical insulator material which should allow for a good heat flow from a heat source to the thermoelectric material. Therefore, thin insulator material layers are necessary and an excellent contacting interface has to be achieved.

Typically, thermoelectric modules incorporate ceramic plates, made for example of $SiO_2$, $Al_2O_3$ or AIN as supports having electrical insulating properties in order to prevent short- circuiting of the generated voltages. Crucially for a good heat flow from the heat source to the thermoelectric materials is a good thermally conductive substrate and an excellent joining of the parts for a minimal heat loss. Additionally, several applications, for example applications with mobile or vibrating parts, require also good mechanical stability of the substrates.

US 2008/0271771 relates to a thermoelectric conversion module which includes a good thermally conductive substrate consisting of aluminum or aluminum alloy having an anode oxide film in order to ensure the electrical insulation. The anode oxidation is an oxidative reaction that occurs on the anode upon the electrolysis, and the anode oxide film of $Al_2O_3$ is formed on a surface of the aluminum or the aluminum alloy by electrolysing the aluminum or the aluminum alloy in an electrolytic solution such as sulphuric acid.

It has been found that oxide films as disclosed in the US-reference are unreliable for preventing short circuits. Also, for high temperature application like heat recovery from exhaust gas, melting beds, motors, the temperature of the source can be as high as 600°C, and owing to the low melting point of 663°C, aluminum supports cannot be used safely.

US 2002/0162338 relates to a laser module, Peltier module or an Peltier module integrated heat spreader. The thermoelectric module described contains metal substrates on which an insulating thin film is formed which lies between the contacts connecting the thermoelectric legs and the substrates. The insulating thin films can be a ceramic thin film, for example of $SiO_2$, $Al_2O_3$, AIN, MgO, or a non-conductive organic material. The insulating thin film can be formed on the surface of the metal substrates by highfrequency pump type ion plating, see page 3, paragraph [0034] and [0035]. According to example 1 the electrical insulating film of $Al_2O_3$ is deposited by means of vacuum deposition, see page 6, paragraph [0070].

US 2007/0028955 relates to a thermoelectric device and method of manufacturing the same. The thermoelectric device has a metal substrate and thermoelectric elements, wherein an insulating layer is provided between the substrates and the thermoelectric legs. The insulating layer is preferably a resin or a resin containing ceramic powder. For example an epoxy resin containing the ceramic powder is employed as the insulating layer, see page 4, paragraph [0073].

The object of the present invention is to provide a thermoelectric module having an improved electrical insulating material on the substrate. Preferably, the substrate should have a higher heat resistance than aluminum.

The object is achieved according to the present invention by a thermoelectric module comprising a series of p and n type semiconductors connected in series by conductive contacts, the conductive contacts being in contact with a substrate of moderate to high thermal conductivity that is electrically insulated from the conductive contacts by a resistive surface layer comprising a ceramic material, wherein the resistive surface layer is formed by a coating of a mixture of glass and ceramic material having a ratio of from 5 to 95 % by weight of ceramic material to 95 to 5 % by weight of glass.

The conductive contacts can e. g. be supported on the substrate or on the semiconduc-tors/thermoelectric material.

The object is furthermore achieved by a process for preparing a thermoelectric module as defined above, involving the step of applying the resistant surface layer to the substrate by electrophoretic deposition.

The object is furthermore achieved by the use of the above thermoelectric module for use as a heat pump, for climate control of seating furniture, vehicles and buildings, in refrigerators and (laundry) driers, for simultaneous heating and cooling of streams in processes for substance separation, as a generator for utilizing heat sources or for cooling electronic components.

The object is furthermore achieved by a heat pump, cooler, refrigerator, (laundry) drier, generator for utilizing heat sources, generator for converting thermal energy to electrical energy, comprising at least one thermoelectric module as defined above.

According to the present invention it was found that ceramic materials form good and secure thin electrically insulating barrier layers on substrates with a coverage over the entire surface of the module. The thermoelectric module according to the present invention has suitable strength properties, is stable at a continuous operational temperature up to 600°C and shows good thermal conductivity as well as good electrical resistance.

The resistive surface layer is formed by a coating of a mixture of glass and ceramic material. The ceramic material can be chosen from a wide variety of ceramic materials which have good insulating properties. Preferably, the ceramic material comprises alumina, zirconia or mixtures thereof. The ceramic material is employed as a mixture with glass, having a ratio of from 5 to 95% by weight of ceramic material to 95 to 5% by weight of glass, preferably 10 to 90% by weight of ceramic material and 90 to 10% by weight of glass, specifically 20 to 80% by weight of ceramic material and 80 to 20% by weight of glass.

The substrate is preferably a metal or a metal alloy, a semimetal, a semiconductor, graphite, electrically conductive ceramics or combinations thereof, preferably a metal or a metal alloy. More preferably, the substrate is a heat resistant steel, iron or nickel alloy. Preferred metal substrates include FeCralloy, Crofer ferritic steel, nickel-plated steel and NiCr-alloys, for example as available under Inconel®. Further metal substrates, which preferably have a higher thermal stability than aluminum or aluminum alloys, are also suited according to the present invention.

The geometric form of the substrate can be chosen from any suitable desired form required by the application. There are no restrictions as to the form of the substrate. Preferably, the metal substrates are flat metal substrates like foils or sheets or derived therefrom by shaping.

It is possible to form a thermoelectric device in which the substrate is formed directly on the hot surface of a body from which it is desired to recover waste heat, for example from the surface of an engine or exhaust pipes. E. g. sheets of the metal substrate can be brought into cylindrical form for inserting in or forming part of an exhaust pipe.

The substrate can haven an unrestricted three-dimensional geometric form which preferably can be obtained by forming a substrate sheet. Thus, the thickness is small with regard to the other dimensions like in sheets, plates, cylinders, circles, etc.

The thickness of the resistive surface layer on the substrate is preferably in the range of from 1 $\mu$m to 500 $\mu$m, more preferably of from 1 to 100 $\mu$m, specifically of from 15 to 35 $\mu$m.

The conductive contacts of the thermoelectric module can be deposited on or applied onto the electrically isolated substrate or they can be deposited on or applied onto the thermoelectric material.

The thermoelectric design according to the present invention allows for the integration of the electrodes on the coated electrically insulated metal substrate. Electrodes can be prepared by several deposition methods, for example lithography, spray, paint, printing, dipping. The specific resistive surface allows for a very uniform electrode having a thickness as desired. High quality electrodes with thicknesses in the range of from 100 nm to 1 mm electrode can be achieved according to the present invention.

Furthermore, according to the present invention, it is possible to embed, clamp or insert the thermoelectric materials in a solid matrix, wherein the matrix material has a low thermal and electrical conductivity and preferably is a ceramic, glass, mica, aerogel or a combination of these materials. The matrix protects the thermoelectric system (materials and contacts) from degradation and contamination due to external factors like humidity, oxygen or chemicals.

This matrix can be clamped or inserted between the two isolated metal substrates. The electrodes can be applied either on the isolated substrate or on the thermoelectric materials. The matrix consists of a material or material mixture with low thermal conductivity, so that the heat flows through the thermoelectric material and not through the matrix. While the above materials are preferred, any non-conductive material with low thermal conductivity may be employed.

The resistive surface layer can be applied to the substrate by all suitable processes. Preferably, the resistive surface layer is applied to the substrate by electrophoretic deposition.

Electrophoretic deposition (EPD) is a term which in context with the invention includes electrocoating, electroplating cathodic electrodeposition, and electrophoretic coating, or electrophoretic painting. A characteristic feature of this process is that colloidal parti-cles suspended in a liquid medium migrate under the influence of an electric field (electrophoresis) and are deposited onto an electrode. All colloidal particles that can form ceramic coating or ceramic containing coatings and can be used to form stable suspensions and that can carry a charge can be used in electrophoretic deposition. This includes material classes such as ceramics and ceramics/glass mixtures.

The process is useful for applying materials to any electrically conductive surface. The materials which are being deposited are the major determining factor in the actual processing conditions and equipment which may be used.

Due to the wide utilization of electrophoretic painting processes in many industries, aqueous EPD is the most common commercially used EPD process. However, non-aqueous electrophoretic deposition applications are known. Applications of non-aqueous EPD are used in the fabrication of electronic components and the production of ceramic coatings. Non-aqueous processes have the advantage of avoiding the electrolysis of water and the gas evolution which accompanies electrolysis.

This process is industrially used for applying coatings to metal fabricated products. It has been widely used to coat automobile bodies and parts, tractors and heavy equipment, electrical switch gear, appliances, metal furniture, beverage containers, fasteners, and many other industrial products.

This process has a number of advantages which have made it widely used

1. The process applies coatings which generally have a very uniform coating thickness without porosity.
2. Complex fabricated objects can easily be coated, both inside cavities as well as on the outside surfaces.
3. Relatively high speed of coating.
4. Relatively high purity.
5. Applicability to wide range of materials (e.g. ceramics, glass etc.)
6. Easy control of the coating composition.
7. The process is normally automated and requires less human labor than other coating processes.
8. Highly efficient utilization of the coating materials result in lower costs relative to other processes.
9. The aqueous process which is commonly used has less risk of fire relative to the solvent-borne coatings that they have replaced.

The overall industrial process of electrophoretic deposition consists of several sub-processes:

1. The object to be coated needs to be prepared for coating. This normally consists of some kind of cleaning process and may include the application of a conversion coating, typically an inorganic phosphate coating.

2. The coating process itself normally involves submerging the part into a container or vessel which holds the coating bath or solution and applying direct current electricity through the EPD bath using electrodes. Typically voltages of 25 - 400 volts DC are used in electrocoating or electrophoretic painting applications. The object to be coated is one of the electrodes, and a set of "counter-electrodes" are used to complete the circuit.

3. After deposition, the object is normally rinsed to remove the undeposited bath.
The rinsing process may utilize an ultrafilter to dewater a portion of the bath from the coating vessel to be used as rinse material. If an ultrafilter is used, all of the rinsed off materials can be returned to the coating vessel, allowing for high utilization efficiency of the coating materials, as well as reducing the amount of waste discharged into the environment.

4. A baking or sintering process is normally used following the rinse. This will allow the coating, which might be porous due to the evolution of gas during the deposition process, to become smooth and continuous.

There are two types of EPD processes, anodic and cathodic. In the anodic process, negatively charged material is deposited on the positively charged electrode, or anode. In the cathodic process, positively charged material is deposited on the negatively charged electrode, or cathode.

When an electric field is applied, all of the charged species migrate by the process of electrophoresis towards the electrode with the opposite charge. There are several mechanisms by which material can be deposited on the electrode.

The deposited coating has significantly higher resistance than the object which is being coated. As the deposited film precipitates, the resistance increases. The increase in resistance is proportional to the thickness of the deposited film, and thus, at a given voltage, the electric current decreases as the film gets thicker until it finally reaches a point where deposition has slowed or stopped occurring (self limiting). Thus the applied voltage is the primary control for the amount of film applied.

The coating temperature is also variable affecting the EPD process. The coating temperature has an effect on the bath conductivity and deposited film conductivity, which increases as temperature increases. Temperature also has an effect on the viscosity of the deposited film, which in turn affects the ability of the deposited film to release any gas bubbles being formed.

In the deposition of ceramic materials, voltages above 3-4V should not be applied in aqueous EPD if it is necessary to avoid the electrolysis of water. However, higher application voltages may be desirable in order to achieve higher coating thicknesses or to increase the rate of deposition. In such applications, organic solvents are used instead of water as the liquid medium. The organic solvents used are generally polar solvents such as alcohols and ketones. Ethanol, acetone, and methyl ethyl ketone are examples of solvents which are suitable candidates for use in electrophoretic deposition.

In the electrophoretic process according to the present invention, the ceramic material preferably comprises alumina, zirconia, titania, silica, boron oxide or mixtures thereof. Further additives or elements like Ba, Sr, Na, Li, K, Pb, Ta, Hf, W, Mo, Cr, Ir, La, In, Ga, typically their oxides, may be present.

The electrophoretic deposition is optionally followed by isostatic pressing followed by sintering to near theoretical density in order to achieve good mechanical stability and good electrical insulation of the metal plates.

Sintering is preferably performed at a temperature in the range of from 650 to 1400 °C in an atmosphere of air or inert gas, especially nitrogen.

As the thermoelectric material, all thermoelectric materials may be employed according to the present invention. Typical thermoelectric materials are e.g. disclosed in US 5,448,109, WO 2007/104601, WO 2007/104603. Pb tellurides are preferred.

The materials are generally produced by reactive grinding or preferably by co-melting and reaction of mixtures of the particular elemental constituents or alloys thereof. In general, a reaction time for the reactive grinding or preferably co-melting of at least one hour has been found to be advantageous.

The thermoelectric materials are prepared generally in an evacuated and sealed quartz tube. Mixing of the components involved can be ensured by use of a rotatable and/or tiltable oven. On completion of the reaction, the oven is cooled. Thereafter, the quartz tube is removed from the oven and the semiconductor material present in the form of blocks is cut into slices. These slices are then cut into pieces of length about 1 to 5 mm, from which thermoelectric modules can be manufactured.

Instead of a quartz tube, it is also possible to use tubes or ampules of other materials which are inert with respect to the semiconductor material, for example of tantalum.

Instead of tubes, it is also possible to use other vessels of a suitable shape. It is also possible to use other materials, for example graphite, as the vessel material, provided that they are inert with respect to the semiconductor material. The materials can also be synthesized by melting/co-melting in an induction oven, for example in graphite ceramic or quartz crucibles.

This gives rise to a process which comprises the following process steps:

(1) co-melting mixtures of the particular elemental constituents or alloys thereof with the at least quaternary or ternary compound;
(2) grinding the material obtained in process step (1);
(3) pressing or extruding the material obtained in process step (2) to moldings
and
(4) optionally sintering the moldings obtained in process step (3).

The semiconductor materials can be combined to form thermoelectric generators or Peltier arrangements by methods which are known per se to the person skilled in the art and are described, for example, in WO 98/44562, US 5,448,109, EP-A-1 102 334 or US 5,439,528.

By varying the chemical composition of the thermoelectric generators or Peltier arrangements, it is possible to provide different systems which satisfy different requirements in a multitude of possible applications. The inventive thermoelectric generators or Peltier arrangements thus widen the range of application of these systems.

The present invention also relates to the use of an inventive thermoelectric module

- as a heat pump
- for climate control of seating furniture, vehicles and buildings
- in refrigerators and (laundry) driers
- for simultaneous heating and cooling of streams in processes for substance separation such as

  - absorption
  - drying
  - crystallization

- evaporation
- distillation

• as a generator for utilization of heat sources such as

- solar energy
- geothermal heat
- heat of combustion of fossil fuels
- waste heat sources in vehicles and stationary units
- heat sinks in the evaporation of liquid substances
- biological heat sources

• for cooling electronic components.
• as a generator for converting thermal energy to electrical energy, for example in motor vehicles, heating systems or power plants

The present invention further relates to a heat pump, to a cooler, to a refrigerator, to a (laundry) drier, to a generator for converting thermal energy to electrical energy or to a generator for utilizing heat sources, comprising at least one inventive thermoelectric module.

The present invention is illustrated in detail with reference to the examples described below.

**Examples**

(a) Ceramic coatings (reference)

The powder materials were an yttria partially-stabilized zirconium oxide from MEL Chemicals, and aluminium oxide from Sumitomo Chemical Company. Suspensions of the materials in amyl alcohol were vibro-energy milled to a particle size distribution with a mean of 0.2 $\mu$m. EPD was carried out on cathodes consisting of 60 mm x 60 mm metallic foil substrates supported around the 4 edges so that the deposition area was 44 mm x 44 mm. The deposition potential was 30 V. To avoid problems of drying cracks due to shrinkage of the deposited film a 3-step process was used.

At each step deposition was carried out for approximately 2 minutes and the coated substrate was then removed from the bath and allowed to dry. This process was repeated so that the total deposition time was approximately 6 minutes.

Coatings of good visual appearance were processed further by isostatic pressing followed by sintering to near theoretical density at various temperatures for 1 hour. The coating thickness was determined from measurements of the deposit weight and area, assuming a theoretical density of 3.965 g/cm$^3$ for alumina and 5.89 g/cm$^3$ for zirconia. The coating thickness was approximately 20 $\mu$m for zirconia and 30 $\mu$m for alumina as shown in tables 1 and 2.

Coated, electrically isolating metal plates were used for electrode deposition. Platinum- gold paint was applied by brush coating to areas of selected samples, after masking the coating. The platinum- gold coating was fired at 800 °C for 30 minutes. Samples labelled X in tables 1 and 2 were evaluated for electrical resistance. The insulting effect of the coating was tested as described below:

The coated test piece was clamped between two stainless steel plates electrically isolated from each other. The pressing force was 2 N/mm$^2$ in the pressed area. Using an external voltage source, a voltage of 15 V was laid on the two steel plates and the electrical current was measured. The minimal detection limit of the current was 0.010 mA.

**Table** 1

| Zirconia coatings | | | | |
|---|---|---|---|---|
| No. | Metal substrate | Coating thickness ($\mu$um) | Sintering T °C/Atmosphere | Ceramic coating resistance |
| 10 | Fecralloy | 18.3 | 1300 air | infinitely |
| 11 | Ferritic steel | 18.7 | 1300 N$_2$ | |
| 12 | Ni-plated steel | 20.0 | None | |
| 13 | Inconel | 20.0 | None | |
| 14* | Fecralloy | 21.2 | 1325 air | 0.75 MOhm |
| 15* | Fecralloy | 21.5 | 1325 air | |

(continued)

| Zirconia coatings | | | | |
|---|---|---|---|---|
| No. | Metal substrate | Coating thickness ($\mu$um) | Sintering T °C/Atmosphere | Ceramic coating resistance |
| 16 | Fecralloy | 21.0 | None | |
| 17* | Fecralloy | 20.8 | 1300 air | |
| 18 | Fecralloy | 20.8 | 1325 air | infinitely |

**Table 2**

| Alumina coatings | | | | |
|---|---|---|---|---|
| No. | Metal substrate | Coating thickness ($\mu$m) | Sintering T °C/Atmosphere | Ceramic coating resistance |
| 19* | Fecralloy | 28.0 | 1325 air | |
| 20* | Ferritic steel | 28.5 | 1300 $N_2$ | infinitely |
| 21 | Ni-plated steel | 26.6 | 1325 Ar/$H_2$ | |
| 22 | Inconel | 26.3 | 1325 Ar/$H_2$ | |
| 23* | Fecralloy | 28.7 | 1325 air | |
| 24 | Fecralloy | 30.2 | 1325 air | infinitely |
| 25 | Fecralloy | 29.3 | 1325 air | infinitely |
| 26 | Fecralloy | 28.4 | 1325 air | |

(b) Glass-ceramic composite coatings

A composite glass-ceramic powder suspension suitable for EPD was produced by grinding the glass to a powder, mixing with the Sumitomo alumina powder and dispersing in alcohol. The glass used in this composite was an aluminoborate glass with the composition 46% $SiO_2$, 25% $B_2O_3$, 10% $Al_2O_3$, 4% $Na_2O$, 3% CaO, 6% SrO and 6% BaO. Trials were carried out to form a composite coating of 80% glass to 20% alumina by weight on Fecralloy foil by EPD with a deposition time of approximately 1 minute. The coating was uniform, adherent, free of texture and free of porosity or microcracks. The thickness of the glass/alumina coating was 7 $\mu$m. Further EPD trials showed that it  was possible to produce glass coatings up to 30 $\mu$m thickness on Fecralloy, but owing to the low thermal conductivity of glass a thin coating is preferred for the thermoelectric application.

Coatings containing other proportions of glass to alumina ranging from 100% glass to 100% alumina are possible by this method. However, because of the low thermal conductivity of glass (1 W/mK) compared to alumina (30 W/mK) a high proportion of glass is not desirable for thermoelectric application. On the other hand a composition with a higher glass content is easier to process, which allows the possibility of fabricating a thinner coating without the risk of pinholes or short-circuiting. Possible embodiments of this aspect of the invention are shown in Table 3.

**Table 3**

| Possible glass: alumina coatings | | |
|---|---|---|
| % glass | % alumina | Thickness ($\mu$m) |
| 0 | 100 | 30 |
| 20 | 80 | 20 |
| 40 | 60 | 10 |
| 80 | 20 | 5 |

(c) Thermally-oxidised Fecralloy (comparison)

Samples of uncoated Fecralloy, both foils and 1 mm thick plates, were heat treated in air at 1100 °C for 2 hours to develop an insulating layer of $\alpha$-Al$_2$O$_3$ formed by thermal oxidation of the alloy. The thickness of the layer was in the range 0.5 to 0.6 $\mu$m. These surface oxide films showed evidence of poor electrical insulation in a test wing pointed electrical contacts.

Samples of uncoated Fecralloy, both foils and 1 mm thick plates, were heat treated at 1100 °C for 2 hours in steam. This thermal treatment resulted in an insulating layer of $\alpha$-Al$_2$O$_3$ formed by steam oxidation of the alloy. The thickness of the layer was in the range 1.5 to 2 $\mu$m. The result of the resistance measurement test shown that this coatings are not sufficiently isolating (at 0.37 mV was measured a current of 2 A).

## Claims

1.  A thermoelectric module comprising a series of p and n type semiconductors connected in series by conductive contacts, the conductive contacts being in contact with a substrate of moderate to high thermal conductivity that is electrically insulated from the conductive contacts by a resistive surface layer comprising a ceramic material, **characterized in that** the resistive surface layer is formed by a coating of a mixture of glass and ceramic material having a ratio of from 5 to 95% by weight of ceramic material to 95 to 5% by weight of glass.

2.  The thermoelectric module according to claim 1, wherein the substrate is a metal, a metal alloy, a semimetal, a semi-conductor, graphite, electrically conductive ceramics or combinations thereof.

3.  The thermoelectric module according to any of claims 1 or 2, wherein the thickness of the resistive surface layer is in the range of from 1 $\mu$m to 500 $\mu$m, preferably of from 1 $\mu$m to 100 $\mu$m.

4.  The thermoelectric module according to any of claims 1 to 3, wherein the conductive contacts are deposited on the electrically insulated substrate.

5.  The thermoelectric module according to any of claims 1 to 3, wherein the conductive contacts are applied onto the thermoelectric materials.

6.  The thermoelectric module according to any of claims 1 to 5, wherein the thermoelectric materials are embedded, clamped or inserted in a solid matrix, wherein the matrix material has a low thermal and electrical conductivity and preferably is a ceramic, glass, mica, aerogel or a combination of these materials.

7.  The thermoelectric module according to any of claims 1 to 6, wherein the substrate is a heat resistant steel, iron or nickel alloy.

8.  The thermoelectric module according to any of claims 1 to 7, wherein the ceramic material comprises alumina, zirconia, titania, silica, boron oxide or mixtures thereof.

9.  The thermoelectric module according to any of claims 1 to 8, wherein the substrate has an unrestricted three-dimensional geometrical form which preferably can be obtained by forming a substrate sheet.

10. A process for preparing a thermoelectric material according to any of claims 1 to 9, involving the step of applying the resistive surface layer to the substrate by electrophoretic deposition.

11. The use of a thermoelectric module according to any of claims 1 to 9 for use as a heat pump, for climate control of seating furniture, vehicles and buildings, in refrigerators and (laundry) driers, for simultaneous heating and cooling of streams in processes for substance separation, as a generator for utilizing heat sources or for cooling electronic components.

12. A heat pump, cooler, refrigerator, (laundry) drier, generator for utilizing heat sources, generator for converting thermal energy to electrical energy, comprising at least one thermoelectric module according to any of claims 1 to 9.

## Patentansprüche

1.  Thermoelektrisches Modul, das eine Reihe von p-und n-Halbleitern umfasst, die durch leitende Kontakte in Reihe geschaltet sind, wobei die leitenden Kontakte mit einem Substrat von moderater bis hoher Wärmeleitfähigkeit in Kontakt stehen, das elektrisch von den leitenden Kontakten durch eine resistive Oberflächenschicht isoliert ist, die ein Keramikmaterial umfasst, **dadurch gekennzeichnet, dass** die resistive Oberflächenschicht durch eine Beschichtung aus einer Mischung aus Glas und Keramikmaterial mit einem Verhältnis von 5 bis 95 Gew.-% Keramikmaterial zu 95 bis 5 Gew.-% Glas ausgebildet ist.

2. Thermoelektrisches Modul nach Anspruch 1, wobei das Substrat ein Metall, eine Metalllegierung, ein Halbmetall, ein Halbleiter, Graphit, elektrisch leitende Keramik oder Kombinationen davon ist.

3. Thermoelektrisches Modul nach einem der Ansprüche 1 oder 2, wobei die Dicke der resistiven Oberflächenschicht im Bereich von 1 $\mu$m bis 500 $\mu$m, bevorzugt von 1 $\mu$m bis 100 $\mu$m, liegt.

4. Thermoelektrisches Modul nach einem der Ansprüche 1 bis 3, wobei die leitenden Kontakte auf dem elektrisch isolierten Substrat abgeschieden sind.

5. Thermoelektrisches Modul nach einem der Ansprüche 1 bis 3, wobei die leitenden Kontakte auf den thermoelektrischen Materialien aufgebracht sind.

6. Thermoelektrisches Modul nach einem der Ansprüche 1 bis 5, wobei die thermoelektrischen Materialien in eine feste Matrix eingebettet, geklemmt oder eingefügt sind, wobei das Matrixmaterial eine geringe thermische und elektrische Leitfähigkeit aufweist und bevorzugt eine Keramik, ein Glas, Glimmer, Aerogel oder eine Kombination aus diesen Materialien ist.

7. Thermoelektrisches Modul nach einem der Ansprüche 1 bis 6, wobei das Substrat wärmebeständiger Stahl, wärmebeständiges Eisen oder eine wärmebeständige Nickellegierung ist.

8. Thermoelektrisches Modul nach einem der Ansprüche 1 bis 7, wobei das Keramikmaterial Aluminiumoxid, Zirkonoxid, Titanoxid, Siliziumoxid, Boroxid oder Mischungen davon umfasst.

9. Thermoelektrisches Modul nach einem der Ansprüche 1 bis 8, wobei das Substrat eine uneingeschränkte dreidimensionale geometrische Form aufweist, die bevorzugt durch Ausbilden einer Substratfolie erhalten werden kann.

10. Prozess zum Herstellen eines thermoelektrischen Materials nach einem der Ansprüche 1 bis 9, beinhaltend den Schritt des Aufbringens der resistiven Oberflächenschicht durch elektrophoretische Abscheidung auf das Substrat.

11. Verwendung eines thermoelektrischen Moduls nach einem der Ansprüche 1 bis 9 zur Verwendung als eine Wärmepumpe, zur Klimasteuerung von Sitzmöbeln, Fahrzeugen und Gebäuden, in Kühlschränken und (Wäsche- ) Trocknern, für das gleichzeitige Erhitzen und Kühlen von Strömen in Prozessen für die Substanztrennung, als ein Generator zum Nutzen von Wärmequellen oder zum Kühlen von Elektronikkomponenten.

12. Wärmepumpe, Kühler, Kühlschrank, (Wäsche_) Trockner, Generator zum Nutzen von Wärmequellen, Generator zum Umwandeln von Wärmeenergie in elektrische Energie, umfassend mindestens ein thermoelektrisches Modul nach einem der Ansprüche 1 bis 9.

## Revendications

1. Module thermoélectrique comprenant une série de semi-conducteurs de type p et n reliés en série par des contacts conducteurs, les contacts conducteurs étant en contact avec un substrat de conductivité thermique modérée à forte qui est électriquement isolé des contacts conducteurs par une couche de surface résistive comprenant un matériau céramique, **caractérisé en ce que** la couche de surface résistive est constituée d'un revêtement d'un mélange de verre et de matériau céramique ayant un rapport de 5 à 95 % en poids de matériau céramique pour 95 à 5 % en poids de verre.

2. Module thermoélectrique selon la revendication 1, dans lequel le substrat est un métal, un alliage métallique, un semi-métal, un semi-conducteur, du graphite, une céramique électriquement conductrice ou une combinaison de ceux-ci.

3. Module thermoélectrique selon l'une quelconque des revendications 1 et 2, dans lequel l'épaisseur de la couche de surface résistive se situe dans la gamme de 1 μm à 500 μm, de préférence de 1 μm à 100 μm.

4. Module thermoélectrique selon l'une quelconque des revendications 1 à 3, dans lequel les contacts conducteurs sont déposés sur le substrat électriquement isolé.

5. Module thermoélectrique selon l'une quelconque des revendications 1 à 3, dans lequel les contacts conducteurs sont appliqués sur les matériaux thermoélectriques.

6. Module thermoélectrique selon l'une quelconque des revendications 1 à 5, dans lequel les matériaux thermoélectriques sont noyés, sertis ou insérés dans une matrice solide, le matériau de la matrice ayant une faible conductivité thermique et électrique et étant de préférence une céramique, du verre, du mica, un aérogel ou une combinaison de ces matériaux.

7. Module thermoélectrique selon l'une quelconque des revendications 1 à 6, dans lequel le substrat est de l'acier, du fer ou un alliage de nickel thermorésistant.

8. Module thermoélectrique selon l'une quelconque des revendications 1 à 7, dans lequel le matériau céramique comprend de l'alumine, de la zircone, du dioxyde de titane, de la silice, de l'oxyde de bore ou un mélange de ceux-ci.

9. Module thermoélectrique selon l'une quelconque des revendications 1 à 8, dans lequel le substrat a une forme géométrique tridimensionnelle non limitée qui de préférence peut être obtenue en façonnant une feuille de substrat.

10. Procédé de préparation d'un matériau thermoélectrique selon l'une quelconque des revendications 1 à 9, impliquant l'étape d'application de la couche de surface résistive au substrat par dépôt électrophorétique.

11. Utilisation d'un module thermoélectrique selon l'une quelconque des revendications 1 à 9 comme une pompe à chaleur, pour la climatisation de meubles d'assises, de véhicules et de bâtiments, dans des réfrigérateurs et des séchoirs (sèche- linge), pour le chauffage et le refroidissement simultanés de courants dans des procédés de séparation de substances, comme un générateur pour l'utilisation de sources de chaleur ou pour le refroidissement de composants électroniques.

12. Pompe à chaleur, refroidisseur, réfrigérateur, séchoir (sèche- linge), générateur pour l'utilisation de sources de chaleur, générateur pour la conversion d'énergie thermique en énergie électrique, comprenant au moins un module thermoélectrique selon l'une quelconque des revendications 1 à 9.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20080271771 A
- US 20020162338 A
- US 20070028955 A
- US 5448109 A
- WO 2007104601 A
- WO 2007104603 A
- WO 9844562 A
- EP 1102334 A
- US 5439528 A

**Non-patent literature cited in the description**

- *Mat. Sci. and Eng.,* 1995, vol. B29, 228